## Europäisches Patentamt
## European Patent Office
## Office européen des brevets

(11) Numéro de publication: **0 116 800**
**B1**

(12) # FASCICULE DE BREVET EUROPÉEN

(45) Date de publication du fascicule du brevet:
**03.02.88**

(51) Int. Cl.⁴: **G 10 K 11/36**

(21) Numéro de dépôt: **83402526.4**

(22) Date de dépôt: **23.12.83**

(54) **Structure épitaxiale à effet piézoélectrique exalté, et dispositif électronique à ondes acoustiques de surface comportant une telle structure.**

(30) Priorité: **30.12.82 FR 8222065**

(43) Date de publication de la demande:
**29.06.84 Bulletin 84/35**

(45) Mention de la délivrance du brevet:
**03.02.88 Bulletin 88/5**

(84) Etats contractants désignés:
**DE GB IT NL**

(56) Documents cité:
**US-A-3 351 786**
**US-A-3 726 585**

**IBM TECHNICAL DISCLOSURE BULLETIN, vol. 15, no. 3, août 1972, pages 928-929, New York, US; V.L.RIDEOUT: "Fabrication of multilayer thin-film piezoelectric transducers"**
**ELECTRONICS LETTERS, vol. 17, no. 12, juin 1981, pages 427-428, Londres, GB; J.HENAFF et al.: "New SSBW mode in GaAs"**
**JAPANESE JOURNAL APPLIED PHYSICS, SUPPLEMENT 16-1, vol. 16, 1977, pages 517-521, Tokyo, JP; K.W.YEH et al.: "Detection of acoustic waves with a PI-DMOS transducer"**

(73) Titulaire: **THOMSON- CSF, 173, Boulevard Haussmann, F-75379 Paris Cédex 08 (FR)**

(72) Inventeur: **Nyen Trong, Linh, THOMSON- CSF SCPI 173, bld Haussmann, F-75379 Paris Cedex 08 (FR)**
Inventeur: **Chevrier, Jean, THOMSON- CSF SCPI 173, bld Haussmann, F-75379 Paris Cedex 08 (FR)**

(74) Mandataire: **Taboureau, James, THOMSON- CSF SCPI 19, avenue de Messine, F-75008 Paris (FR)**

## Description

La présente invention concerne une structure épitaxiale à effet piézoélectrique exalté, offrant la possibilité d'intégrer sur un même cristal en matériau semiconducteur un ou plusieurs composants piézoélectriques, et des composants électroniques. L'invention concerne le domaine des ondes acoustiques de surface.

Les ondes acoustiques de surface sont largement utilisées en microélectronique dans la réalisation de lignes à retard, de flitres adaptés à des signaux codés ou de convoluteurs par exemple. En général, un système électronique de ce type est composé de deux parties distinctes, l'une réalisant la fonction acoustique, l'autre la fonction électronique de traitement de signal, chacune des deux parties étant constituée d'un matériau différent de celui de l'autre partie.

Les ondes élastiques peuvent traiter des signaux électriques dans une gamme de fréquences s'étendant de quelques mégahertz à plusieurs gigahertz, et l'exploitation de filtres à ondes de Rayleigh a apporté une solution elégante au problème du filtrage des signaux de radars modernes par exemple. Mais la structure de ces flitres n'est simple que si le substrat est piézoélecbique. Cette contrainte restreint en pratique le nombre des matériaux utilisables: par exemple quartz ($SiO_2$), niobate de lithium ($LiNbO_3$) et tantalate de lithium ($LiTaO_3$). En vue d'élargir le choix des matériaux possibles et des fonctions réalisables, des recherches sont entreprises dans le but de déposer des couches piézoélectriques, par exemple nitrure d'aluminium (AIN) ou oxyde de zinc (ZnO) sur divers substrats tels que verre ou alumine. Des structures du type "couche de ZnO sur substrat silicium" permettent une intégration hybride. C'est ainsi que l'article "Detection of Acoustic Waves with a PI-DMOS Transducer" publié dans Japanese Journal of Applied Physics, Vol. 16, (1977), suplement 16-1, PP 517-521, décrit un transistor MOS dans lequel une couche piézoélectrique de ZnO est introduite entre la métallisation de grille et la couche active, faisant de ce transistor un détecteur piézoélectrique sensible aux ondes de volume et de surface.

Pour des raison évidentes- plus l'intégration est poussée, meilleure est la fiabilité- il est intéressant d'intégrer les deux fonctions acoustique et électronique sur un seul substrat, cristal semiconducteur monolithique permettant de réaliser les deux fonctions à la fois. Cependant, la plupart des matériaux connus comme matériaux semiconducteurs, Si, GaAs, InP... etc ne sont pas piézoélectriques (Si) ou le sont peu (Ga As, InP...).

Un exemple de transducteuur acoustique intégré sur un substrat en matériau semiconducteur est décrit dans IBM Technical Disclosure Bulletin, vol 15, N°3 août 1972, pp928-929. Il comporte un super-réseau de couches de Ge non piézoélectrique et de couches de GaAs faiblement piézoélectrique, régulièrement alternées, se terminant par deux couches de Ge très dopé pour faire fonction d'électrode. Le substrat est indifféremment en Ge oû GaAs. Pour éviter de voir apparaitre des dislocations de réseau au cours de la croissance épitaxale des couches, les matériaux sont choisis pour être en bon accord de paramètre de maille et de structure cristalline : Ge, AIAs, GaAs, ZnTe. Mais précisément parce que les matériaux sont accordés en paramètres de mailles, celui qui n'est pas piézoélectrique ne déforme pas celui qui est piézoélectrique. Il y a donc une simple addition de la faible piézoélectricité de quelques couches de GaAs, séparées par des couches inactives de Ge. Cet effet d'addition est moins fort qu'un effet d'amplification.

Sélon l'invention, l'effet piézoélecbique d'un matériau apte à la realisation d'un composant semiconducteur mais faiblement piézoélectrique est accru par distorsion de son réseau cristallin, afin d'en accroître la dissymétrie qui est génératrice de l'effet piézoélectrique. La piézoélectricité du matériau est donc exaltée, puisqu'elle est forcée par la distorsion voulue de son réseau cristallographique, distorsion obtenue par le désaccord des paramètres de mailles cristallines entre le substrat et la couche dans laquelle est recherché l'effet piézoélectrique.

Mais, étant donné par ailleurs que l'effet piézoélectrique exalté par la contrainte s'exerce sur une faible épaisseur, qui sera analysée plus loin, et qui ne dépasse pas 200 Å en moyenne, mais que par contre les ondes de surface se déplacent sur une profondeur de l'ordre de plusieurs milliers d'angströms, les structures selon l'invéntion sont constitueés par une pluralité de couches du matériau à effet piézoéléctriqué exalté, alternant avec une pluralité de couches du matériau du substrat, ou d'un matériau ayant le même paramètre cristallin, chaque interface entre deux couches successives, désaccordées en paramètre de mailles, distordant le réseau cristallin de la couche piézoélectrique.

De façon plus précise, l'invention concerne une structure épitaxiale à effet piézoélectrique comportant, supportées par un substrat semi-isolant, une pluralité de couches épitaxiées, formant deux groupes de couches, constituées de deux matériaux régulièrement alternés, cette structure étant caractérisée en ce que le premier matériau du premier groupe de couches a un paramètre de mailles cristallines égal à celui du substrat, le second matériau du second groupe de couches a un paramètre de mailles cristallines différent de celui du substrat et étant de plus piézoélectrique, le désaccord du paramètre cristallin entre le substrat et les couches du premier groupe qui impose aux couches du second groupe une contrainte de déformation du réseau cristallin.

L'invention sera mieux comprise par la description d'un exemple de structure à effet piézoélectrique exalté, laquelle s'appuie sur les figures jointes en annexes, qui représentent:

- figure 1: coupe schématique de deux reseaux cristallins, en accord de mailles cristallines,
- figure 2: coupe schématique de deux réseaux cristallins, désadaptés en paramètres de mailles,
- figure 3: graphique donnant l'épaisseur de la couche épitaxique sous contrainte, en fonction de la désadaptation des réseaux,
- figure 4: coupe schématique d'une structure multicouches à effet piézoélectrique,
- figure 5: coupe d'une structure intégrée monolithique à ondes acoustiques de surface élelectronique de traitement de signal,
- figure 6: variante de la structure précéndente.

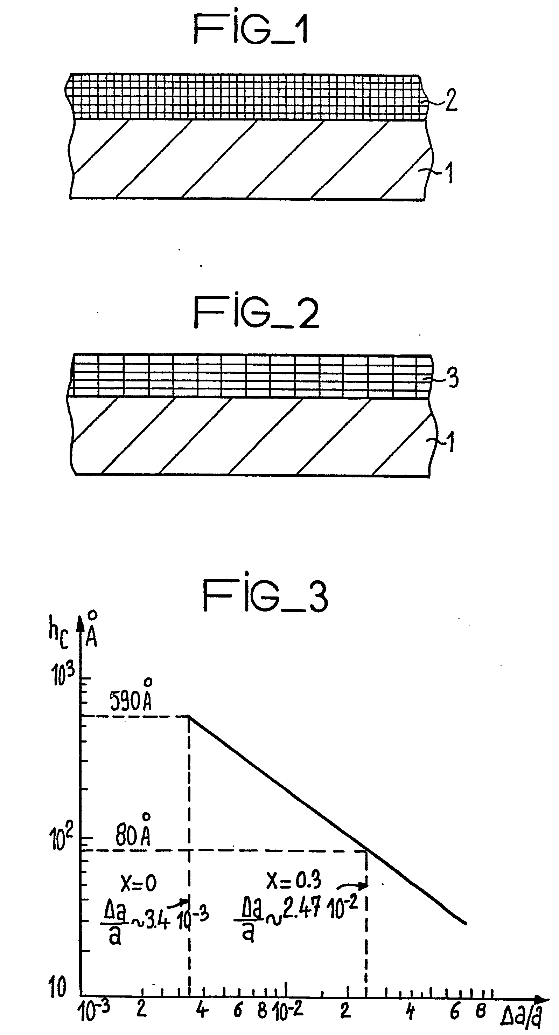

Les figures 1 et 2 montrent comment l'effet piézoélectrique d'un matériau peut être exalté, ce qui signifie que le réseau cristallin d'un matériau à l'origine peu piézoélectrique est déformé. L'augmentation obtenue de l'effet piézoélectrique résulte du déplacement relatif des charges électriques dans le réseau cristallin, et donc de la formation de dipôles.

Sur ces figures, le réseau cristallin de la couche épitaxiée est, par convention, représenté par un réseau de droites définissant des carrés lorsque le cristal n'est pas déformé, et un rectangle si le cristal est déformé. Cette représentation schématique ne sous-entend pas que le système cristallin est forcément du type cubique ou que la relation épitaxiale a lieu selon un axe cristallographique déterminé. En effet les considérations qui suivent sont absolument générales et s'appliquent dans tout système épitaxial. Par contre, afin de donner plus de précision à la description de l'invention, celle-ci sera décrite en s'appuyant sur un exemple de réalisation d'un circuit électronique comportant un dispositif à ondes de surface sur un même substrat du type GaAs, ou, plus généralement, des familles III-V, II-VI, IV-VI.

La figure 1 représente, déposée par épitaxie sur un substrat 1, une couche 2 en parfait accord épitaxial avec son substrat, c'est-à-dire que les paramètres de mailles sont tels que le réseau cristallin de la couche 2 correspond parfaitement aux paramètres de maille du substrat 1. De tels systèmes existent par exemple:

$Ga_xIn_{1-x}As_yP_{1-y}$ et InP, ou $Al_xGa_{1-x}As_yP_{1-y}$ et GaAs.

La figure 2 représente le cas où une couche épitaxiale 3 est en épitaxie forcée avec le substrat 1: la couche 3 est constituée d'un matériau de paramètre cristallin différent de celui du substrat. L'épitaxie a lieu par déformation plastique du réseau cristallin de la couche épitaxiale 3. On considère ici que la couche épitaxiale est beaucoup plus mince que le substrat, par conséquent, sa déformation plastique y est beaucoup plus importante. Le cas représenté sur la figure 2 correspond à un étirement du réseau cristallin de la couche 3, son paramètre cristallin ($a_3$) étant plus petit que celui ($a_1$) du substrat. Dans le cas où le paramètre cristallin ($a_3$) de la couche épitaxiée est plus grand que le paramètre cristallin ($a_1$) du substrat, la couche épitaxiée est en compression, mais l'effet de déformation du réseau cristallin reste comparable.

Si la désadaptation des réseaux cristallins est trop importante pour que les contraintes puissent être absorbées entièrement par l'élasticité du matériau, il se crée des dislocations de désadaptation de réseau (DAR), et la contrainte est relâchée. La densité de dislocation dépend du paramètre du désaccord cristallin $\Delta a_3 = a_3 - a_1$ et des propriétés mécaniques du matériau.

En général, une couche épitaxiale dépaisseur très fine absorbe la désadaptation de réseau par élasticité, mais si cette épaisseur devient importe la rigidité de la couche s'accroît et peut créer les dislocations DAR. L'épaisseur à laquelle se produisent les dislocations DAR pour un matériau donné est appelée épaisseur critique $h_c$. J.W Matthews, A.E Blakeslee et S.Mader (Thin solid Films, 33 (1976)253), ont montré que $h_c$ est défini par l'équation:

$$h_c = \frac{b \quad (1 - \nu\cos^2\alpha)}{8\pi \quad \frac{\Delta a}{a}(1 + \nu)\cos\lambda} \; Log\left(\frac{h_c}{b}\right)$$

$\nu$ est le coefficient de Poisson
$\alpha$ l'angle entre le vecteur de Burger $\overrightarrow{b}$

et la ligne de dislocation qui s'étend dans le plan d'interface
$\lambda$ l'angle entre $\overrightarrow{b}$

et la direction à l'interface, qui est perpendiculaire à la ligne d'intersection du plan de glissement et du plan d'interface
$\frac{\Delta a}{a}$ le désaccord de paramètre de maille

Cette équation peut se simplifier, de manière approximative, en:
$h_c = \frac{b}{2\Delta a/a}$

La figure 3 représente la variation de $h_c$ en fonction de $\Delta a/a$, c'est-à-dire l'épaisseur de la couche épitaxiale sous contrainte, sans dislocation, en fonction du désaccord de paramètre de maille, dans le cas d'une couche 3 de $Al_{1-x}In_xAs$ sur un substrat 1 de GaAs. Il est bien évident que cet exemple ne limite pas la portée de l'invention. Ainsi, pour un couple de matériaux donnés la relation simplifiée permet de fixer l'épaisseur limite qu'il ne faut pas dépasser pour garder la couche épitaxiale sous contrainte. La variation de $h_c$ en fonction de $\Delta a/a$ est, dans le cas le plus général, une droite à pente négative: il est évident que l'épaisseur de la couche sous contrainte devient d'autant plus faible que le paramètre de désaccord $\Delta a/a$ devient plus important. Celui-ci est d'ailleurs en relation directe avec l'indice x dans la formule $Al_xIn_{1-x}As$.

La courbe de la figure 3 montre que pour avoir une déformation importante de la maille cristalline telle que $\Delta a/a \; 10^{-2}$, il faut se limiter pour la couche épitaxiée à des épaisseurs plus faibles que 200 Å. Une telle couche mince n'est pas suffisante pour faire propager les ondes acoustiques de surface, puisque l'on sait que la profondeur de pénétration des ondes acoustiques de surface est de l'ordre de plusieurs milliers d'angströms, c'està-dire environ 1 micron.

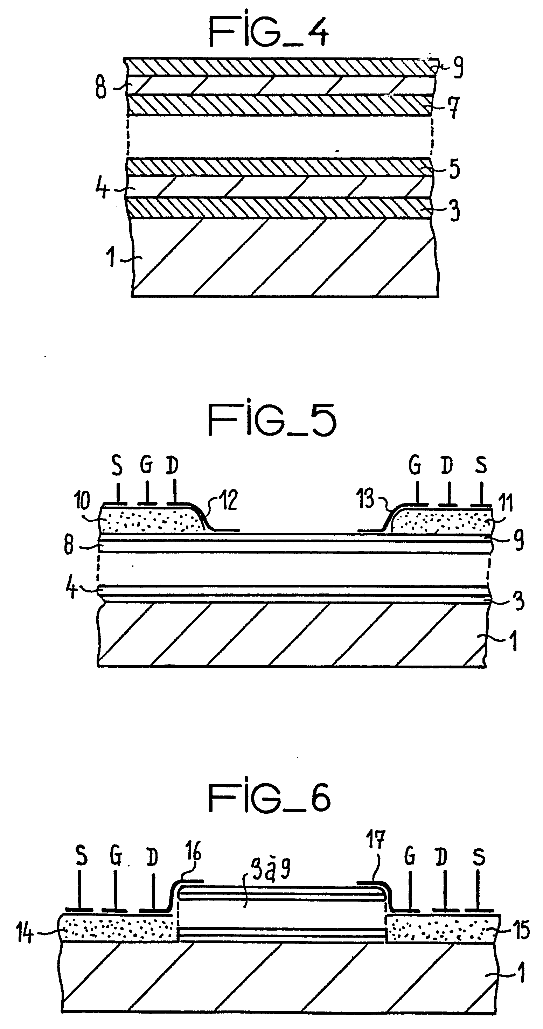

Afin de disposer d'épaisseur de plusieurs milliers d'angströms de couches sous contrainte sans se heurter pour autant à la limitation par l'épaisseur critique $h_c$, l'invention consiste à réaliser des empilements de couches épitaxiales en épitaxie forcée, alternées avec des couches de mêmes paramètres cristallin que le substrat. Les couches en épitaxie forcée ont bien entendu une épaisseur inférieure à l'épaisseur critique $h_c$, de façon à ne pas être disloquées par désadaptation de réseau. Par contre, les couches qui ont même paramètre de mailles que le substrat, ou tout au moins un paramètre de mailles différent de celui des couches épitaxiales contraintes ont, quant à elles, une épaisseur suffisante pour n'être pas déformées par les couches épitaxales. La figure 4 représente la coupe schématique d'un tel empilement à effet piézoélectrique exalté.

Afin de simplifier les explications, cette figure sera exposée en admettant qu'elle correspond au couple de matériaux GaAs/$Al_xIn_{1-x}$As, avec x = 0,3. Sur le substrat 1 en GaAs, on dépose d'abord une couche 3 de $Al_{0,3}In_{0,7}$As d'épaisseur inférieure à 80 Å, par exemple 50 Å, puis une couche 4 de GaAs, d'épaisseur de l'ordre de celle de $Al_{0,3}In_{0,7}$As, puis une nouvelle couche 5 de $Al_{0,3}In_{0,7}$As de 50 Å environ, et ainsi de suite, jusqu'à ce que l'ensemble des empilements atteignent une épaisseur suffisante pour la propagation des ondes acoustiques de surface.

L'épitaxie des couches est obtenue par différentes techniques connues, telles qu'en phase gazeuse, par décomposition d'organométalliques (MOCVD) ou par jets moléculaires.

La première couche (3) déposée sur le substrat est "déformée" par celui-ci, en raison de la désadaptation du réseau. La seconde couche (4) déposée est une couche "déformante": son interface avec la couche inférieure (3) tend à déformer le réseau de cette couche déjà déposée, et elle déforme aussi la troisième couche (5) dont l'épitaxie va croître avec un réseau cristallin défomé. L'épitaxie de la couche 5 est donc forcée, et l'effet piézoélectrique de cette même couche est exalté. La structure selon l'invention comporte donc une succession de couches dites "déformées" et "déformantes" - dans le seul but de simplification -, ce qui ne signifie nullement que ces couches ne soient pas planes, les couches déformantes ayant un paramètre de mailles égal ou voisin de celui du substrat et ne participant pas à l'effet piézoélectrique, tandis que les couches déformées, dont l'effet piézoélectrique est exalté, ont un paramètre de mailles déformé par celui du substrat.

La succession de couches "déformées" et "déformantes" est répétée jusqu'à obtenir une épaisseur suffisante pour l'usage requis. On conviendra que les couches 8 et 9 sont respectivement les dernières couches déformante et déformée en surface de la structure.

L'avantage de la structure à effet piézoélectrique exalté selon l'invention est qu'elle met en oeuvre des matériaux semiconducteurs, tandis que les structures connues mettent en oeuvre des matériaux qui ne sont pas des semiconducteurs, en ce sens qu'on ne sait pas ou ne peut pas en faire par exemple un transistor: l'oxyde de zinc, le niobate et le tantalate de lithium.

Cet avantage est mis à profit pour intégrer sur un même substrat un dispositif comportant un semiconducteur et un empilement piézoélectrique à ondes de surface.

La figure 5 représente un tel dispositif, dans un premier exemple de réalisation.

Pour conserver le couple de matériaux choisi pour exposer la figure 3 - et sans que cet exemple ne soit limitatif- ce dispositif comporte un substrat 1 en GaAs semi-isolant, et un empilement de couches "déformées" 3,5...7,9 en $Al_{0,3}In_{0,7}$As, en épitaxie forcée, et de couches "déformantes" 4...8 en GaAs, ces deux types de couches étant bien entendu alternés. Il comporte également des fonctions électroniques d'entrée et de sortie, réalisées dans une couche superficielle de n GaAs dans le cas choisi pour l'exemple. Cette couche de n GaAs est épitaxiée à la surface libre de l'empilement à effet piézoélectrique, puis est attaqué, soit par gravure chimique, soit par usinage ionique, de façon à ne laisser subsister que deux îlots 10 et 11, aux deux extrêmités de la ligne à onde de surface.

Les fonctions électroniques représentées en figure 5 sont des transistors à effet de champ, symbolisés par leurs trois électrodes de source S, grille G et drain D mais ils ne sont pas détaillés volontairement. En effet, appartiennent au domaine de l'invention plusieurs cas:

-les transistors avec des métallisations sur une simple couche 10 - 11 de n GaAs,

-les transistors du type à hétérofonction, et la couche 10 - 11 de n GaAs est complétée par au moins une couche formant hétérojonction, de type $Al_yGa_{1-y}$As par exemple, ou bien ce sont des MOSFET et une couche d'isolant ($SiO_2$) isole la grille,

-les transistors peuvent également ne pas être à effet de champ, mais être bipolaires,

- des circuits électroniques plus complexes qu'un simple transistor, servant d'amplification ou de traitement de signal.

Quel que soit le dispositif adopté, il y a au moins une liaison électrique 12 entre le dispositif d'entrée et une liaison électrique 13 pour le dispositif de sortie, afin d'assurer l'excitation de la ligne à ondes de surface et le traitement des signaux, et afin également d'assurer la liaison électrique entre deux surfaces qui ne sont pas au même niveau (épaisseur de la couche épitaxiée 10 - 11).

La figure 6 représente le même dispositif intégré dans une seconde forme de réalisation.

Ce qui différencie la seconde forme de la première est l'ordre des opérations. Ainsi, le dispositif de la figure 6 est obtenu en épitaxiant d'abord, sur un substrat 1 en GaAs semi-isolant, une couche de n GaAs. Celle-ci est attaquée pour ne laisser subsister que deux ilôts 14 et 15 dans lesquels seront réalisés les transistors. Puis l'empilement des couches sous contraintes, "déformées" et "déformantes" 3 à 9, est réalisé par épitaxie: cette suite d'opérations recouvre également les deux ilôts 14 et 15 qui doivent être dégagés, à la fin des opérations, pour pouvoir déposer les métallisations d'électrodes, ainsi que les métallisations 16 et 17 de liaisons transistors - dispositif piézoélectrique.

Les remarques qui ont été faites au sujet de la figure 5 concernant les dispositifs électroniques restent entièrement valables pour cette configuration de dispositif. Ils peuvent être des diodes ou des transistors à effet de champ ou bipolaires, plus ou moins complexes, et c'est la raison pour laquelle le dessin en est symbolisé.

L'invention a été exposée en s'appuyant sur un couple (GaAs-Al$_{1-x}$ In$_x$As) de la famille III-V: d'autres matériaux de cette même famille III-V, ou des familles II-VI, tels que CdS ou CdTe, ou IV-VI tel que PbTe, conviennent également à la réealisation de dispositifs piézoélectriques intégrés.

L'invention trouve son application dans la réalisation de circuits intégrés monolithiques dans lesquels, outre les fonctions électroniques courantes - diodes, transistors, amplificateurs...etc - se trouve au moins un élément à effet piézoélectrique, pour réaliser des lignes à retard, des filtres de bandes, des filtres adaptés à des signaux codés ou des convoluteurs par exemple.

## Revendications

1. Structure épitaxiale à effet piézoélectrique comportant, supportées par un substrat semi-isolant (1), une pluralité de couches épitaxiées, formant deux groupes de couches (4, 8) (3, 5, 7, 9), constituées de deux matériaux régulièrement alternés, cette structure étant caractérisée en ce que le premier matériau du premier groupe de couches (4, 8) a un paramètre de mailles cristallines égal à celui du substrat (1), le second matériau du second groupe de couches (3, 5, 7, 9) a un paramètre de mailles cristallines différent de celui du substrat (1) et est de plus faiblement piézoélectrique, l'effet piézoélectrique des couches du second groupe (3, 5, 7, 9) étant exalté par le désaccord du paramètre cristallin entre le substrat (1) et les couches (4, 8) du premier groupe qui impose aux couches (3, 5, 7, 9) du second groupe une contrainte de déformation du réseau cristallin.

2. Structure épitaxiale selon la revendication 1, caractérisée en ce que l'épaisseur des couches sous contrainte (3, 5, 7, 9) du second groupe est inférieure à l'épaisseur critique h$_c$ à laquelle apparaissent les dislocations de réseau cristallin, pour un désaccord du paramètre de mailles $\Delta a/a$ donné, cette épaisseur critique h$_c$ étant égale à:

$$h_c = \frac{cste}{2\Delta a/a}$$

dans laquelle:cste $= \overrightarrow{b}$

= vecteur de Burger.

3. Structure épitaxiale selon la revendication 1, caractérisée en ce que l'épaisseur totale des couches épitaxiées (3 à 9) est égale à $\approx 1$ μm et permet la propagation des ondes acoustiques de surface.

4. Structure épitaxiale selon la revendication 1, caractérisée en ce que le couple des matériaux utilisés pour le substrat (1) et les couches (4, 8) du premier groupe, d'une part, et pour les couches (3, 5, 7, 9) du secod groupe, d'autre part, est choisi parmi les composés de la famillie III-V (Ga, In-As, P, Sb).

5. Structure épitaxiale selon la revendication 1, caractérisée en ce que le couple de matériaux utilisés pour le substrat (1) et les couches (4, 8) du premier groupe, d'une part, et pour les couches (3, 5,7,9) du second groupe d'autre part, est choisi parmi les composés de la famille II-VI (Cd, Te, S).

6. Structure épitaxiale selon la revendication 1, caractérisée en ce que le couple des matériaux utilisés pour le substrat (1) et les couches (4, 8) du premier groupe, d'une part, et pour les couches (3, 5, 7, 9) du second groupe, d'autre part, est choisi parmi les composés de la familie IV-VI (PbTe).

7. Structure épitaxiale selon la revendication 1, caractérsée en ce qu'elle intègre en plus sur le même substrat (1), de façon monolithique, au moins un dispositif électronique réalisé dans au moins un ilôt (10) de matériau semiconducteur déposé sur la surface libre de la structure piézoélectrique, le dispositif électronique étant en contact électrique avec ladite structure par l'intermédiaire d'une metallisation (12).

8. Structure épitaxiale selon la revendication 1, caractérisée en ce qu'elle intègre en plus sur le même substrat (1), de façon monolithique, au moins un dispositif électronique, réalisé dans au moins un ilôt (4) de matériau semiconducteur déposé sur la surface libre substrat (1) à côté de la structure piézoélectrique, le dispositif électronique étant en contact électrique avec ladite structure par l'intermédiaire d'une métallisation (16).

9. Dispositif électronique à ondes acoustiques de surface, caractérisé en ce qu'il comporte au moins une structure épitaxiale monolithique, à effet piézoélectrique exalté, selon l'une quelconque des revendications 1 à 8.

## Patentansprüche

Epitaxialstrukt·:r mit piezoelektischem Effekt, die auf einem halbisolierenden Substrat (1) mehrere Epitaxialschichten aufweist, welche zwei Gruppen von Schichten (4, 8) (3, 5, 7, 9) aus zwei regelmäßig alternierenden Materialien bilden, dadurch gekennzeichnet, daß das erste Material der ersten Gruppe von Schichten (4, 8) einen Kristallgitterparameter gleich dem des Substrats (1) besitzt, daß das zweite Material der zweiten Gruppe von Schichten (3, 5, 7, 9) einen Kristallgitterparameter ungleich dem des Substrats besitzt und außerdem etwas piezoelektrisch ist, wobei der piezoelektrische Effekt der Schichten der zweiten Gruppe (3, 5, 7, 9) durch den Unterschied im Kristallparameter zwischen dem Substrat (1) und den Schichten (4, 8) der ersten Gruppe überhöht wird, der den Schichten (3, 5, 7, 9) der zweiten Gruppe eine Verformungsvorspannung des Kristallgitters verleiht.

2. Epitaxialstruktur nach Anspruch 1, dadurch gekennzeichnet, daß die Dicke der unter Vorspannung stehenden Schichten (3, 5, 7, 9) der zweiten Gruppe geringer als die kritische Dicke $h_c$ ist, bei der die Versetzungen des Kristallgitters für einen gegebenen Unterschied $\Delta a/a$ des Gitterparameters auftreten, wobei diese kritische Dicke $h_c$ gleich ist

$$h_c = cste/2\,\Delta a/a$$

wobei $cste = \vec{b}$

= Burgervektor ist.

3. Epitaxialstruktur nach Anspruch 1, dadurch gekennzeichnet, daß die Gesamtdicke der Epitaxialschichten (3 bis 9) ungefähr gleich 1 μm ist und die Fortpflanzung der akustischen Oberflächenwellen erlaubt.

4. Epitaxialstruktur nach Anspruch 1, dadurch gekennzeichnet, daß das Paar von Materialien, die einerseits für das Substrat (1) und die Schichten (4, 8) der ersten Gruppe und andererseits für die Schichten (3, 5, 7, 9) der zweiten Gruppe verwendet werden, aus den Stoffen der Familie III-V (Ga, In-As, P, Sb) gewählt wird.

5. Epitaxialstruktur nach Anspruch 1, dadurch gekennzeichnet, daß das Paar von Materialien, die einerseits für das Substrat (1) und die Schichten (4, 8) der ersten Gruppe und andererseits für die Schichten (3, 5, 7, 9) der zweiten Gruppe verwendet werden, aus den Stoffen der Familie II-VI (Cd, Te, S) ausgewählt wird.

6. Epitaxialstruktur nach Anspruch 1, dadurch gekennzeichnet, daß das Paar von Materialien, die einerseits für das Substrat (1) und die Schichten (4, 8) der ersten Gruppe und andererseits für die Schichten (3, 5, 7, 9) der zweiten Gruppe verwendet werden, aus den Stoffen der Familie IV-VI (PbTe) ausgewählt wird.

7. Epitaxialstruktur nach Anspruch 1, dadurch gekennzeichnet, daß sie außerdem in monolithischer Weise auf demselben Substrat (1) mindestens eine elektronische Vorrichtung aufweist, die in mindestens einer Insel (10) aus Halbleitermaterial ausgebildet ist, das auf die freie Oberfläche der piezoelektrischen Struktur aufgebracht ist, wobei die elektronische Vorrichtung über eine Metallbeschichtung (12) mit der Struktur in elektrischem Kontakt steht.

8. Epitaxialstruktur nach Anspruch 1, dadurch gekennzeichnet, daß sie außerdem auf demselben Substrat (1) in monolithischer Weise mindestens eine elektronische Vorrichtung aufweist, die in mindestens einer Insel (4) aus auf die freie Oberfläche des Substrats (1) neben der piezoelektrischen Struktur aufgebrachtem Halbleitermaterial gebildet ist, wobei die elektronische Vorrichtung über eine Metallbeschichtung (16) mit der Struktur in elektrischem Kontakt steht.

9. Elektronische Vorrichtung mit akustischen Oberflächenwellen, dadurch gekennzeichnet, daß sie mindestens eine monolithische Epitaxialstruktur mit überhöhtem piezoelektrischem Effekt nach einem beliebigen der Ansprüche 1 bis 8 enthält.

## Claims

1. A piezoelectric epitaxial structure which comprises on a semi-insulating substrate (1) a plurality of epitaxy layers constituting two groups of layers (4, 8) (3, 5, 7, 9) made of two regularly alternating materials, characterized in that the first material of the first group of layers (4, 8) has a cristal lattice parameter equal to that of the substrate (1), that the second material of the second group of layers (3, 5, 7, 9) has a cristal lattice parameter different from that of the substrate (1) and is moreover slightly piezoelectric, the piezoelectricity effect of the layers of the second group (3, 5, 7, 9) being exalted by the detuning of the cristal parameter between the substrate (1) and the layers (4, 8) of the first group which imposes onto the layers (3, 5, 7, 9) of the second group a deformation load of the cristal lattice.

2. An epitaxial structure according to claim 1, characterized in that the thickness of the layers under load (3, 5, 7, 9) of the second group is smaller than the critical thickness $h_c$ at which the dislocations of the cristal lattice appear for a given detuning $\Delta a/a$ of the lattice parameter, this critical thickness $h_c$ being equal to

$$h_c = cste/\Delta a/a$$

in which $cste = \vec{b}$

= Burger vector.

3. An epitaxial structure according to claim 1, characterized in that the total thickness of the epitaxy layers (3 to 9) is equal to about 1 μm and allows the propagation of acoustic surface waves.

4. An epitaxial structure according to claim 1, characterized in that the pair of materials employed on the one hand for the substrate (1) and the layers (4, 8) of the first group and on the other hand for the layers (3, 5, 7, 9) of the second group is chosen among the substances belonging to the family III-V (Ga, In-As, P, Sb).

5. An epitaxial structure according to claim 1, characterized in that the pair of materials employed on the one hand for the substrate (1) and the layers (4, 8) of the first group and on the other hand for the layers (3, 5, 7, 9) of the second group is chosen among the substances belonging to the family II-VI (Cd, Te, S).

6. An epitaxial structure according to claim 1, characterized in that the pair of materials employed on the one hand for the substrate (1) and the layers (4, 8) of the first group and on the other hand for the layers (3, 5, 7, 9) of the second group is chosen among the substances belonging to the family IV-VI (PbTe).

7. An epitaxial structure according to claim 1, characterized in that it further integrates on the same substrate (1) in a monolithic manner at least one electronic device realized in at least one island (10) made of semiconductor material which is deposited on the free surface of the piezoelectric structure, the electronic device being in electrical contact with said structure via a metallisation (12).

8. An epitaxial structure according to claim 1, characterized in that it further integrates on the same substrate (1) in a monolithic manner at least one electronic device realized in at least one island (4) made of semiconductor material and deposited on the free surface of the substrate (1) beside the piezoelectric structure, the electronic device being in electrical contact with said structure via a metallisation (16).

9. An electronic device of the acoustic surface wave type, characterized in that it comprises at least one epitaxial monolithic structure with exalted piezoelectric effect according to any one of claims 1 to 8.

0 116 800

FIG_1

FIG_2

FIG_3

# FIG_4

# FIG_5

# FIG_6